Europäisches Patentamt

European Patent Office

Office européen des brevets

(11) Veröffentlichungsnummer: **0 482 241 A1**

# EUROPÄISCHE PATENTANMELDUNG

(21) Anmeldenummer: **90120509.6**

(22) Anmeldetag: **25.10.90**

(51) Int. Cl.5: **H01L 29/73**, H01L 29/08

(43) Veröffentlichungstag der Anmeldung:
**29.04.92 Patentblatt 92/18**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Lenz, Michael**
**Herzogplatz 50**
**W-8011 Zorneding(DE)**
Erfinder: **Lachmann, Ulrich**
**Zirlerstrasse 11**
**W-8000 München 70(DE)**
Erfinder: **Erckert, Ricardo, Dipl.-Ing.**
**Schwaneckstrasse 2**
**W-8000 München 70(DE)**
Erfinder: **Starke, Oskar, Dipl.-Ing.**
**Hardenbergstrasse 29**
**W-8000 München 50(DE)**
Erfinder: **Larik, Joost, Dipl.-Ing.**
**Rotenburgerstrasse 239**
**W-8500 Nürnberg(DE)**

(54) **Integrierte bipolare Transistoranordnung.**

(57) Die erfindungsgemäße Transistorstruktur weist eine Emitterzone (5) auf, die von einer epitaktischen Schicht (7) vollkommen umschlossen ist. Emitterzone (5) und epitaktische Schicht (7) sind in die Basiszone (4, 8) eingebettet, die wannenförmig innerhalb einer auf dem Substrat (1) ausgebildeten epitaktischen Schicht (2) angeordnet ist. Zwischen Halbleitersubstrat und epitaktischer Schicht (2) befindet sind ein buried-layer (3), der bis an die Basiszone (4, 8) angrenzt. Die Basiszone (4, 8) ist ringförmig von einer Kollektorzone (6) umgeben, die von der Oberfläche bis in den buried-layer Bereich (3) reicht. Der Grundriß der Basiszone (4, 8) hat maximale Fläche und minimalen Umfang.

FIG 2

Die Erfindung bezieht sich auf eine integrierbare bipolare Transistoranordnung nach dem Oberbegriff des Anspruchs 1.

Treten innerhalb einer integrierten Schaltung Spannungen auf, die außerhalb des Versorgungsspannungsbereichs der integrierten Schaltung liegen, wie etwa beim Betrieb mit induktiven Lasten, so werden intern parasitäre Schaltungsstrukturen aktiviert. Es werden beispielsweise pn-Übergänge zwischen einem p-dotierten Substrat und mehreren n-Wannen gebildet, die beim Betrieb in Flußrichtung parasitäre Dioden- und Transistorstrukturen ergeben. Dabei wird jeder n-dotierten Wanne Strom entzogen, was in bestimmten Fällen zu Funktionsstörungen einzelner Schaltungsstrukturen oder zur Beschädigung der integrierten Schaltung führen kann.

Schaltkreise mit offenem npn-Kollektorausgang zeigen Funktionsstörungen, wenn durch äußere Störsignale der Kollektor des Ausgangstransistors in gesperrtem Zustand verpolt wird. Verursacht werden diese Störungen durch den Elektronenstrom, der bei Verpolung von der Wanne des Ausgangstransistors in Nachbarwannen fließt.

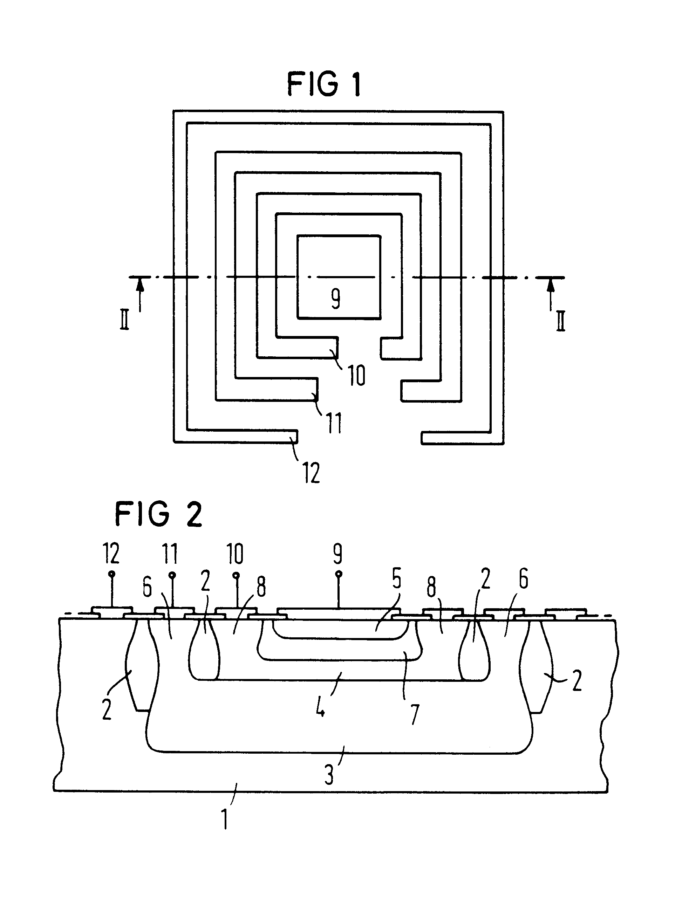

Der Effekt dieser parasitären Strukturen ist aus "Bipolar and MDS Analog Integrated Design", Alan B. Grebene, Aufl. 1983, S. 54ff bekannt. FIG 2.1. zeigt einen Vergleich zwischen diskreten und integrierten npn-Transistorstrukturen. In FIG 2.1.b ist zu sehen, daß durch Nachbarwanne, Substrat und n-Epitaxieschicht des npn-Transistors ein parasitärer lateraler npn-Transistor gebildet wird. Im Falle des integrierten Transistors ist der Transistor von einem p-n-Übergang umgeben, der aus p-Substrat, buried-layer-Gebiet, n-epitaktischer Schicht und einem p±Ring besteht, der durch die Epitaxie hindurch bis zum Substrat reicht. Dieser Übergang isoliert den Transistor elektrisch von anderen auf dem Chip integrierten Bausteinen. Durch diesen p-n-Übergang kann ein besagter parasitärer npn-Transistor aktiviert werden, wenn das Potential am Kollektor negativer als das Substratpotential wird.

Eine Möglichkeit, die Aktivierung derartiger parasitärer Strukturen zu vermeiden, bietet der Inversbetrieb des npn-Transistors. Hierfür muß allerdings die Durchbruchsspannung des inversen Transistors der jeweiligen Spezifikation entsprechen. Bisherige Transistoranordnungen in integrierten Schaltungen weisen eine beschränkte Durchbruchsspannung des Emitter-Basisüberganges auf.

Weiterhin ist bekannt, Ausgänge von integrierten Schaltungen gegenüber unzulässigen Spannungen mit einer Schottkydiode parallel zur Substratdiode, mit einer Klammerschaltung oder mit Freilaufdioden zu schützen.

Aufgabe der Erfindung ist es, eine integrierbare bipolare Transistoranordnung anzugeben, bei der ein parasitärer Substrattransistor vermieden wird und eine hohe Durchbruchsspannung gewährleistet ist.

Die Aufgabe wird gelöst durch die kennzeichnenden Merkmale des Anspruchs 1. Weiterbildungen sind Kennzeichen der Unteransprüche.

Vorteil der Erfindung ist es, daß zur Vermeidung der Aktivierung parasitärer Strukturen keine zusätzlichen Freilaufdioden notwendig sind. Die erfindungsgemäße Transistoranordnung kann in jeder integrierten Schaltung verwendet werden.

Durch die Verwendung einer bipolaren Technologie mit Doppelisolation und unter Berücksichtigung ausreichend großer Abstände zwischen Emitterzone 5 und den beiden Isolationsschichten 4 und 8 wird außerdem eine hohe Durchbruchsspannung für den Inversbetrieb gewährleistet.

Die Erfindung wird nachfolgend anhand von zwei Figuren näher erläutert. Es zeigen:

FIG 1     eine Draufsicht auf die Epitaxieschicht eines erfindungsgemäßen integrierbaren bipolaren Transistors,

FIG 2     einen Querschnitt durch einen integrierbaren bipolaren Transistor nach FIG 1 längs der Linie A.

In den Figuren 1 und 2 sind gleiche Elemente mit gleichen Ziffern belegt.

Nach FIG 1 ist ein erfindungsgemäßer bipolarer Transistor derart ausgebildet, daß eine Emitterzone 9 ringförmig von der Basiszone 10 umgeben ist. Die Basiszone hat vorzugsweise einen Grundriß, dessen Fläche maximal und dessen Umfang minimal ist. Die Basiszone 10 kann dabei auf der Kontaktierungsfläche eine Öffnung aufweisen, durch die eventuelle Anschlüsse zur Emitterzone geführt werden können. Im Halbleiterkristall ist die Emitterzone vollständig von der Basiszone umgeben. Die Basiszone 10 ist wiederum im Abstand von der Kollektorzone 11 umgeben. Auch diese kann wie die Basiszone 10 eine Öffnung zur Durchführung von Anschlüssen aufweisen. Letztendlich umschließt die Substratanschlußzone 12 den Transistor. Auch dieser kann wieder eine Öffnung zur Durchführung von Anschlüssen aufweisen.

Der Aufbau eines erfindungsgemäßen bipolaren integrierbaren Transistors wird anhand von FIG 2 deutlich. In einem Substrat 1, das z. B. aus einem Halbleiter, insbesondere Silizium bestehen kann, ist ein buried-layer-Bereich 3 eindotiert. Ebenfalls im Substrat 1 ist eine untere Isolationsschicht 4 eindotiert, die im Bereich des buried-layer-Bereichs 3 diesem überlagert ist. Auf der Oberfläche ist eine ganzflächige Epitaxieschicht 2 abgeschieden. Kollektor-Tiefdiffusionsbereiche 6 sind von der Oberfläche so in die Epitaxieschicht 2 eingebracht, daß sie bis in die buried-layer-Schicht 3 hineinragen. Oberhalb der buried-layer-Schicht 3 zwischen den Kollektor-Tiefdiffusionsbereichen 6 befindet sich der Basisbereich. Dieser wird durch obere Isolationsbereiche 8 gebildet, die von der Oberfläche so in die Epitaxieschicht 2 eingebracht sind, daß sie bis in die untere Isolationsschicht 4 hineinragen.

Die untere Isolationsschicht 4, angrenzend an den buried-layer-Bereich 3 bildet die aktive Basiszone, die in die aktive Basiszone hineinragende obere Isolationsschicht 8 die kontaktierende Basiszone. Innerhalb der verbleibenden, vollkommen von der Basiszone umschlossenen Epitaxiewanne 7 ist die bis zur Oberfläche reichende Emitterzone 5 eingebettet. Der Transistor wird von seiner Umgebung isoliert durch den außerhalb des buried-layer-Bereich 3 angeordneten p-Ring, bestehend aus den beiden Isolationsschichten 4 und 8. Die Emitterzone 5 ist mit der Emitterleitbahn 9 kontaktiert. Desgleichen ist die Basiszone mit der Basisleitbahn 10 und der Kollektorzone mit der Kollektorleitbahn 11 kontaktiert. Daß den Transistor umgebende Substrat ist ebenfalls über einer Substratleitbahn 12 kontaktiert.

Für einen erfindinngsgemäßen npn-Transistor können folgende Leitungstypen verwendet werden. Das Halbleitersubstrat 1 und die kontaktierende Basiszone 8 sind vom $p^+$- und die aktive Basiszone 4 vom p-Leitungstyp. Die epitaktische Schicht 2,7 ist vom $n^-$-und die Emitterzone 5, der buried layer 3 und die Kollektorzone 6 vom $n^+$-Leitungstyp.

Durch die gewählte Struktur weist die Kollektorseite des inversen Transistors (= Emitterzone) eine ausreichende Raumladungszone auf. Dies wird dadurch gewährleistet, daß zwischen dem hochdotierten Emittergebiet und der Basiszone, sowohl lateral als auch vertikal ein ausreichend großes niedrig dotiertes Epitaxiegebiet vorhanden ist. Die Kollektordurchbruchsspannung wird auf diese Weise gegenüber üblichen Transistoren deutlich heraufgesetzt. Durch das Driftfeld der aktiven Basiszone wird außerdem die Stromverstärkung des inversen Transistors günstig beeinflußt.

Im Vergleich zu einem normal betriebenen npn-Transistor mit einem Substratstromanteil von nahezu 100 % des Kollektorstroms bei Verpolung, hat die erfindungsgemäße Transistorstruktur einen Substratstromanteil von 0,1 % des Kollektorstroms bis zu einem Verpolstrom von 100 mA. Dabei fließt etwa 1 % des Substratstroms in die Nachbarwanne.

**Patentansprüche**

1. Integrierbare bipolare Transistoranordnung, bei der auf einem Halbleitersubstrat (1) eines ersten Leitungstyps eine bis zur Oberfläche des Halbleiterkörpers reichende epitaktische Schicht (2) von einem zweiten Leitungstyp vorgesehen ist, bei der zwischen epitaktischer Schicht (2) und Halbleitersubstrat (1) eine buried-layer-Zone (3) vom zweiten Leitungstyp vorgesehen ist, bei der zwischen buried-layer-Zone (3) und Oberfläche eine aktive Basiszone (4) vom ersten Leitungstyp und in der Basiszone (4) eine wannenförmige Emitterzone (5) vom zweiten Leitungstyp vorgesehen ist, bei der eine im Abstand von der Basiszone die Basiszone ringförmige umschließende Kollektorzone (6) vom zweiten Leitungstyp vorgesehen ist, die von der Oberfläche bis in die buried-layer-Zone (3) reicht,
**dadurch gekennzeichnet,**
daß die Emitterzone (5) in einer wannenförmigen epitaktischen Schicht (7) eingebettet ist, die gegenüber der Emitterzone (5) schwächer dotiert und vom gleichen Leitungstyp ist, und daß die wannenförmige epitaktische Schicht (7) von einer kontaktierenden Basiszone (8) vom ersten Leitungstyp ringförmig umgeben ist, die bis zur aktiven Basiszone (4) reicht, und die aktive Basiszone (4) zwischen epitaktische Schicht (7) und buried-layer-Zone (3) angeordnet ist.

2. Integrierbare bipolare Transistoranordnung nach Anspruch 1,
**dadurch gekennzeichnet,**
daß der Grundriß der aktiven Basiszone (4) eine maximale Fläche mit minimalem Umfang hat.

3. Integrierbare bipolare Transistoranordnung nach Anspruch 2,
**dadurch gekennzeichnet,**
daß die kontaktierende Basiszone (8) und die Kollektorzone (6) die Emitterzone in konstanten Abstand umschließen.

## FIG 1

## FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-A-3 910 526  (ROBERT BOSCH GMBH.) <br> * Spalte 3, Zeilen 20 - 42; Figur 4 * <br> – – – | 1-3 | H 01 L 29/73 <br> H 01 L 29/08 |
| X | US-A-4 038 680  (SONY CORP.) <br> * Spalte 9, Zeilen 18 - 54; Figur 6L * <br> – – – – – | 1-3 | |

RECHERCHIERTE SACHGEBIETE (Int. Cl.5)

H 01 L

Der vorliegende Recherchenbericht wurde für alle Patentansprüche erstellt

| Recherchenort | Abschlußdatum der Recherche | Prüfer |
|---|---|---|
| Den Haag | 13 Juni 91 | NILES N.P.E. |